(19) Europäisches Patentamt
European Patent Office
Office européen des brevets

(11) **EP 3 855 499 B1**

(12) **EUROPEAN PATENT SPECIFICATION**

(45) Date of publication and mention
of the grant of the patent:
**29.10.2025 Bulletin 2025/44**

(21) Application number: **20197625.5**

(22) Date of filing: **23.09.2020**

(51) International Patent Classification (IPC):
*H10F 39/00* (2025.01)     *H10F 39/18* (2025.01)

(52) Cooperative Patent Classification (CPC):
**H10F 39/8063; H10F 39/024; H10F 39/1898;
H10F 39/8057**

(54) **RADIATION IMAGE DETECTOR**

STRAHLUNGSBILDDETEKTOR

DÉTECTEUR D'IMAGES À RAYONNEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.01.2020  CN 202010072176
12.06.2020  US 202016899618**

(43) Date of publication of application:
**28.07.2021  Bulletin 2021/30**

(73) Proprietor: **Iray Technology Company Limited
Shanghai 201206 (CN)**

(72) Inventors:
• **GU, Tieer**
**Pudong New Area, Shanghai, 201206 (CN)**
• **HUANG, Zhongshou**
**Pudong New Area, Shanghai, 201206 (CN)**

(74) Representative: **Rösler Rasch van der Heide &
Partner
Bodenseestraße 18
81241 München (DE)**

(56) References cited:
**EP-A1- 2 383 586     US-A1- 2016 021 319
US-A1- 2017 234 992**

## Description

### TECHNICAL FIELD

The present disclosure pertains generally to the field of radiation detectors and, more particularly, to the field of radiation image detectors.

### BACKGROUND

Flat panel X-ray image detectors have been widely used in digital radiography for medical diagnosis and radiotherapy. Compared with traditional X-ray films, the flat panel image detector has the advantages of fastness, low cost, low exposure, high image quality, etc., and is convenient for data archiving, transmission and image processing, and is readily integrated into PACS (Picture Archiving and Communication Systems). US 2017/234992 A1 refers to an imaging apparatus and a manufacturing method thereof. An imaging apparatus includes a photoelectric conversion layer, a light guide layer, and a scintillator layer. The photoelectric conversion layer has a plurality of pixel regions configured to be capable of performing photoelectric conversion. The light guide layer has a convex region formed to be convex toward an opposite side of the photoelectric conversion layer for each of the pixel regions, and is formed on the photoelectric conversion layer. The scintillator layer is formed directly on the light guide layer. US 2016/021319 A1 refers to a semiconductor device, an imaging device, and an electronic device. A first circuit has a function of generating an optical data signal in accordance with the amount of irradiation light and a function of generating a reset signal corresponding to a reset state of the first circuit. A second circuit has a function of controlling output of the optical data signal and the reset signal from the first circuit to a fourth circuit. A third circuit has a function of controlling generation of the reset signal to be output from the first circuit to the fourth circuit. The fourth circuit has a function of calculating the difference between the optical data signal input from the first circuit and the reset signal input from the first circuit after input of the optical data signal. EP 2 383 586 A1 refers to a compact, hybrid and integrated gamma/RF system which is used to form simultaneous PET or SPECT and MR images, comprising a gamma/RF device including an RF coil of the type used in traditional MR systems, and gamma radiation detection modules of the type used in PET or SPECT systems, such as to produce combined images using PET or SPECT and MR techniques.

An image detector in the related art is provided with a radiation conversion layer and a visible light image detector. First, the radiation is converted to visible light through the radiation conversion layer; then the visible light is converted to electrical signals through a photoelectric conversion device in the visible light image detector; and finally the electrical signals are readout to an external circuit to complete the detection of the radiation image. With increase of clinic adoption of the flat panel X-ray detectors, the demand for higher image quality is increasing. The image quality is characterized by detective quantum efficiency (DQE) or alternatively modulation transfer function (MTF) and signal to noise ratio (SNR). Therefore increase MTF and SNR is the primary object of this disclosure.

### SUMMARY

Embodiments of the present disclosure provide a radiation image detector, which improves light utilization of the image detector and therefore increases image MTF and SNR.

In a first aspect, an embodiment of the present disclosure provides a radiation image detector, the radiation image detector includes a substrate, an optical image detector located on the substrate and including an array including a plurality of photosensitive pixels arranged periodically, a radiation conversion layer located on a side of the optical image detector facing away from the substrate and configured to convert radiation into visible light, and a plurality of light-collecting structures. Each photosensitive pixel of the plurality of photosensitive pixels includes a first electrode, a photoelectric conversion layer, and a second electrode. The first electrode includes a first contact surface in direct contact with the photoelectric conversion layer, the second electrode includes a second contact surface in direct contact with the photoelectric conversion layer, and the photoelectric conversion layer includes a central region and a side wall region. The central region includes a portion where an orthographic projection of the first contact surface onto the photoelectric conversion layer and an orthographic projection of the second contact surface onto the photoelectric conversion layer overlap with each other, and the side wall region includes a region of the photoelectric conversion layer other than the central region. The optical image detector also includes a plurality of trench regions in a certain width, insensitive to light and surrounding each of the plurality of photosensitive pixels of the array. Each of the plurality of light-collecting structures is pixelated and located between the plurality of photosensitive pixels and the radiation conversion layer, and is configured to guide visible light to the central region, that the visible light would otherwise fall into the side wall region or a trench region between each photosensitive pixels. Each of the plurality of light-collecting structures (104) comprises a first portion (B1) which overlaps on the central region (ZQ), and a second portion (B2) which overlaps on both the sidewall region (BQ) and the trench regions (JQ). From the central region (ZQ) to the trench region (JQ), thickness of the second portion (B2) in the direction perpendicular to the substrate (101) gradually decreases while thickness of the first portion (B1) in the direction perpendicular to the substrate (101) is kept the same. The maximum thickness (H) of the second portion (B2) satisfies the following equations: $0.5(W2+W3) \geqq H \geqq (W2+W3)$, where W2 is the width of the side wall region (BQ), and W3 is the width of the trench regions(JQ).

A portion of light generated in the radiation conversion layer may enter into the trench region where no light detector exists, or enter into side-wall region in a light detector where electric field is not strong enough to drive photo-generated charges to the corresponding electrodes. The light-collecting structure provided in the present disclosure deflects and guides the portion of the light that would enter into the trench region or the side wall region, into the central region of the light detector, which ensures approximately all light photons are converted into electron-hole pairs and nearly all the electron-hole pairs are separated and collected by the electrodes.

## BRIEF DESCRIPTION OF DRAWINGS

These and other features, aspects, and advantages of the present disclosure will become better understood when the following description is read with reference to the accompanying drawings in which like characters represent like parts throughout the drawings, wherein:

FIG. 1 is a prior art of a typical flat panel radiation image detector;
FIG. 2 is a cross-sectional view of a radiation image detector according to an embodiment of the present disclosure;
FIG. 3 is a plane view of a photosensitive pixel array in a radiation image detector according to an embodiment of the present disclosure;
FIG. 4 is a plane view of a radiation image detector according to an embodiment of the present disclosure;
FIG.5 is a cross-sectional view along a cutting line A-A' illustrated in FIG. 4;
FIG. 6 is a schematic illustrating an optical path of visible light in a radiation image detector after irradiating to a light-collecting structure according to an embodiment of the present disclosure;
FIG. 7 is a schematic of a radiation image detector according to another embodiment of the present disclosure;
FIG. 8 is a schematic of a radiation image detector according to another embodiment of the present disclosure;
FIG. 9 is a schematic of a radiation image detector according to another embodiment of the present disclosure;
FIG. 10 is a plane view of a radiation image detector according to another embodiment of the present disclosure; and
FIG. 11 is a cross-sectional view along a cutting line B-B' illustrated in FIG. 10 according to an embodiment.

## DESCRIPTION OF EMBODIMENTS

In order to make the features, aspects and advantages of the present disclosure better understood, the technical solutions of the present disclosure will be described in details below with reference to the accompanying drawings. It should be noted that the described embodiments are merely a part of implementations of the present disclosure, rather than all of the implementations or varieties based upon the concept disclosed in the present disclosure. All other embodiments obtained by those skilled in the art without creative efforts according to the embodiments of the present disclosure shall fall within the scope of the present disclosure.

The terms used in the embodiments of the present disclosure is for the purpose of describing particular embodiments only and are not intended to limit the present disclosure. The terms in singular forms "a" "the" and "said" used in the embodiments of the present disclosure and the appended claims are also intended to include plural forms, unless the context clearly indicates other meanings.

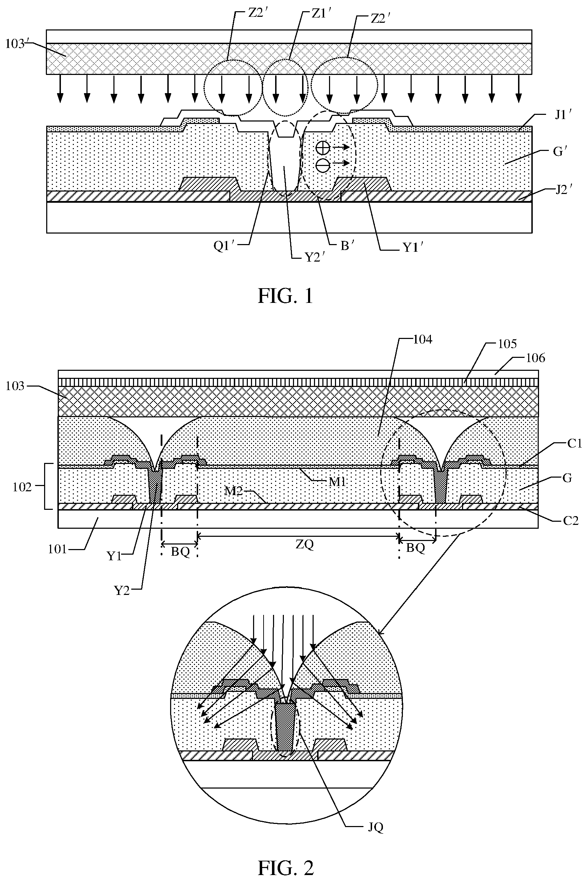

FIG. 1 is a cross-sectional view of a radiation image detector in a prior art. As shown in FIG. 1, two photosensitive pixels and a spacing region Q1' between them are illustrated. Incident radiation is converted into visible light first by a radiation conversion layer 103', and then the visible light enters into an image detector below the conversion layer 103'. As illustrated in FIG.1 , visible light emitted from a region Z1' right above the spacing region Q1' may not enter into the photoelectric conversion layer G', resulting in a reduced utilization of the visible light. In addition to the loss of the visible light from the region Z1', light emitted from a region Z2', which is right above an edge region B' of the photoelectric conversion layer G', may not contribute to image signal fully as well. As illustrated in FIG. 1, the photoelectric conversion layer G' is sandwiched by an upper electrode J1' and a bottom electrode J2', with exception around the edge of the photoelectric conversion layer, marked as the edge region B'. The photoelectric conversion layer G' may comprise (not shown in FIG. 1) an N-doped layer and a P-doped layer at the top and bottom surfaces, to server as Ohmic contact with the top electrode J1' and the bottom electrode J2', respectively. As a consequence, due to high resistance of the thin doped layers or simply due to lack of contact electrodes in the edge region B', the electric field in the edge region B' is not strong enough to either separate the electron-hole pairs generated in the edge region B', nor pull the electrons or holes to the corresponding electrodes. Electron-hole pairs will recombine quickly, resulting zero contribution to image signal. Another detrimental effect associated with this zero or low bias condition in the edge region B' is short term to long term image lags.

As schematically illustrated in FIG. 1, electrons or holes generated in the edge area B' must travel laterally a longer distance relatively to the thickness of the photoelectric conversion layer G', to the upper electrode J1' or the bottom electrode J2'. The electrons or holes (i.e., photo-generated carriers) have a higher probability of being captured by various energy traps during such a long journey. Releasing of the captured charge carriers in subsequent image frames becomes a source of image lags. Therefore, the device structure in the edge region B in the prior arts not only has a reduced photoelectric conversion efficiency but also has a detrimental effect to the image quality.

One of the reasons that both the top electrode J1 and the bottom electrode J2 have recesses from the edge of the photoelectric conversion layer (or photodiode island after lithography patterning), is to avoid high sidewall leakage current. Manufacturing process in minimum dimension, caused mainly by accuracy of lithography process, will determine the minimum width of the recess from the edge of the photoelectric layer. Therefore the above described drawbacks, including the loss of signal and image lags, are always associated with the device structure in the prior arts unless a new structure is introduced.

Micro-lens array has been employed in CCDs and CMOS imaging sensors, which are made on tiny silicon chips with pixel dimensions less than 10um. In the solution, one micro-lens having substantially the same size as each pixel is fabricated above each pixel to guide or focus all the light to the photodiode in the CCD or the CMOS imaging sensor. However, given the pixel size in a flat panel X-ray image detector, which can be as large as 100um or even 200 $\mu$m, the height of each micro-lens would be in the same order of magnitude of pixel size to perform as a convex lens. This requirement leads to a great challenge in manufacturing process.

In order to overcome the drawbacks mentioned above, a radiation image detector comprising a pixelated light-collecting structure is conceived and disclosed in details in the following.

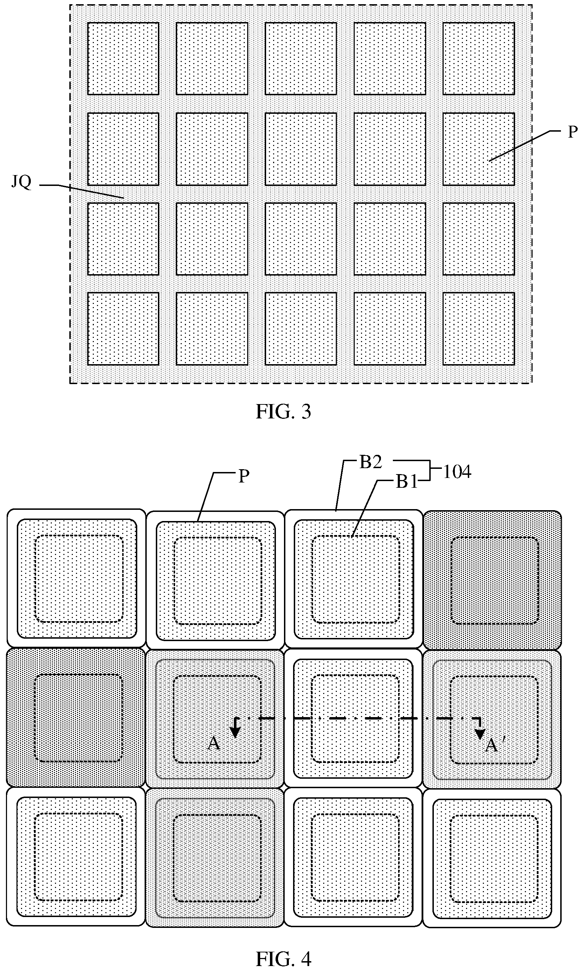

FIG. 2 is a cross-sectional view of a radiation image detector according to an embodiment of the present disclosure. FIG. 3 is a plane view of a photosensitive pixel array in the radiation image detector shown in FIG. 2.

As shown in FIG. 2, the radiation image detector includes a substrate 101, and an optical image detector 102 located on the substrate 101. In an embodiment, the substrate 101 can be a flexible substrate or a rigid substrate.

The optical image detector 102 includes an array of photosensitive pixels P, arranged periodically. As shown in t FIG. 3, each photosensitive pixel P is surrounded by a trench region JQ (spacing region), which is insensitive to light. The width of the trench region JQ is generally defined by the accuracy of the manufacturing process, the size of the substrate 101, and the resolution requirements of the radiation image detector.

As shown in FIG. 2, the photosensitive pixel P includes a first electrode C1, a photoelectric conversion layer G, and a second electrode C2. The first electrode C1 includes a first contact surface M1 that is in direct contact with the photoelectric conversion layer G, and the second electrode C2 includes a second contact surface M2 that is in direct contact with the photoelectric conversion layer G.

The photoelectric conversion layer G can be divided into at least two portions, a central region ZQ and a side wall region BQ. The central region ZQ includes a portion where an orthographic projection of the first contact surface M1 onto the photoelectric conversion layer G and an orthographic projection of the second contact surface M2 onto the photoelectric conversion layer G overlap with each other. The side wall region BQ surrounds the central region ZQ. When a bias voltage is applied to the first electrode C1 or the second electrode C2, electron-hole pairs generated in the central region ZQ will be separated, and the electrons and holes will drift to the anode and the cathode, respectively.

The radiation image detector further includes a radiation conversion layer 103 overlaid on the entire optical image detector, and an array of light-collecting structure 104 (pixelated light-collecting structure). The radiation conversion layer 103 is positioned above the optical image detector 102 and configured to convert radiation into visible light. The radiations can be X-rays with energy ranging from 1 KeV to several hundred KeV or $\gamma$ (Gamma) rays which may have higher energy exceeding 1 MeV in energy distribution. The radiation conversion layer 103 comprises scintillator or phosphors, such as cesium iodide (doped with Thallium CsI(Tl), or CdWO4 or GOS (Gd2O2S:Pr).

The pixelated light-collecting structure 104 is sandwiched by the photosensitive pixel P and the radiation conversion layer 103, and particularly has a curved surface near the edge of the pixel and convex toward the radiation conversion layer. As shown in the enlarged view in FIG. 2, the visible light that would fall into the trench region JQ or all into the side wall region BQ is then guided to the central region ZQ by the curved surface on the light-collecting structure 104.

Benefiting from the light-collecting structure, photoconversion efficiency is improved and so does the image lag performance.

With increase of resolution in the flat panel X-ray imaging sensor, the pixel size will be reduced accordingly, but the trench area and the side-wall region may not be downsized in the same scale, mainly due to lithography and various process limitations. Implementation of the light-collecting structure as disclosed in the embodiment into high resolution radiation image detector will have more significant improves in efficiency and image quality.

It should be noted that the radiation image detector further includes an external circuit. The external circuit is electrically connected to the photosensitive pixels. The electrical signals corresponding to the photo-generated charges in each pixel is readout by the external circuit. The external circuit is configured to perform arithmetic processing on the electric signals and then generate images according to the incident radiation on the flat panel detector.

As illustrated in FIG. 2, the radiation image detector further includes a reflective layer 105 and a cover plate 106. The reflective layer 105 is located on a side of the radiation conversion layer 103 facing away from the optical image detector 102, and the cover plate 106 is located on a side of the reflective layer 105 facing away from the radiation conversion layer 103. The cover plate 106 is made of light mass materials that can be easily penetrated by radiation, such as a carbon fiber thin plate or an aluminum alloy plate. The cover plate 106 can be a flat cover plate or a curved cover plate. The reflective layer 105 is made of materials with high reflection for visible light, such as aluminum or silver in the forms of thin film or nano particles.

As illustrated in FIG. 2, for the purpose of reducing side-wall leakage, the trench region JQ is filled with the second insulating layer Y2 to isolate the photoelectric conversion layer from its neighbors. The peripheral of the second electrode C2 is guarded by the first insulating layer Y1, defining an opening of the first insulating layer Y1, the area of the second contact surface M2, and the boundary of the central region ZQ as well. For the same purpose of reducing side-wall leakage, both the first and the second electrode Y1 and Y2 have lateral recesses from the edges of the photoelectric conversion layer G.

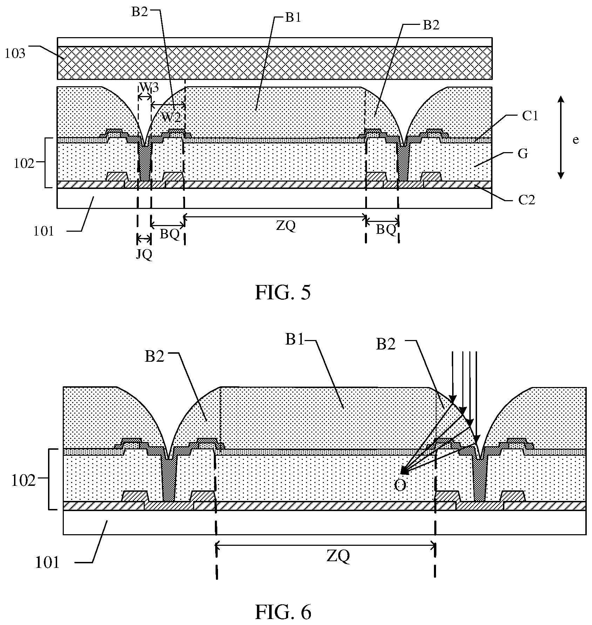

A plane view of a radiation image detector as an embodiment of the present disclosure is shown in FIG.4, a cross-sectional view along a cutting line A-A' illustrated in FIG. 4 is shown in FIG.5.

Referring to FIG. 4 and FIG. 5, the radiation image detector comprises an array of the photosensitive pixels P and an array of the light-collecting structure 104, superimposing each other. The light-collecting structure 104 consists essentially a first portion B1 and a second portion B2.

As shown in FIG. 5, the first portion B1 overlaps with the central region ZQ, and the second portion B2 overlaps with both the side wall region BQ and the trench region JQ. The thickness of the second portion B2 gradually decreases from the central region ZQ to the trench region JQ, forming a smooth curved or sloped surface or a surface like a convex lens. Contrary to the curved surface in B2, the surface of the first portion B1 is essentially flat, or in another words its thickness remains essentially equal to the largest thickness of the second portion B2. Therefore, the total thickness of the light collection structure is limited by the thickness of the portion B2, which may be in the range of tens micrometers or even less, the same order of magnitude as the dimensions of the trench region and the side-wall region. Fabrication of the light collecting structure based on a conventional process is therefore readily feasible.

In the embodiment of the present disclosure, the second portion of the light-collecting structure serves as a partial convex lens above the side wall region and the trench region, focusing or guiding those light photons, that would fall into the trench region or the side-wall region, to the central region of the photoelectric conversion layer.

With continued reference to FIG. 5, assume the width of the side wall region BQ is W2, the width of the trench region JQ is W3, and the maximum thickness of the second portion B2 is H, it is preferred that the value of H is in the range from $0.5 * (W2 + W3)$ to $(W2 + W3)$. Beyond this range, either the light collecting structure is too small to efficiently collect the majority of the light photons generated above the trench region and the side-wall region, or the light collecting structure is unnecessarily too large to make the fabrication process complicated and high cost.

As shown in FIG. 4, the second portion B2 of the light collecting structure looks like a ring-shaped convex lens, surrounding the first portion of the light collecting structure B1, with a focal point inside of the central region. FIG. 6 is a schematic diagram of the optical path of visible light while the light photons interacting with the light-collecting structure. As schematically illustrated in FIG. 6, a collimated light beam is refracted at the surface of the light collecting structure and converged into the central region ZQ, ideally at a focal point O. Benefiting from the light collecting structure as described above, the utilization of the incident light increases, improved, those detrimental effects such as image lags are minimized, and finally the image quality is improved.

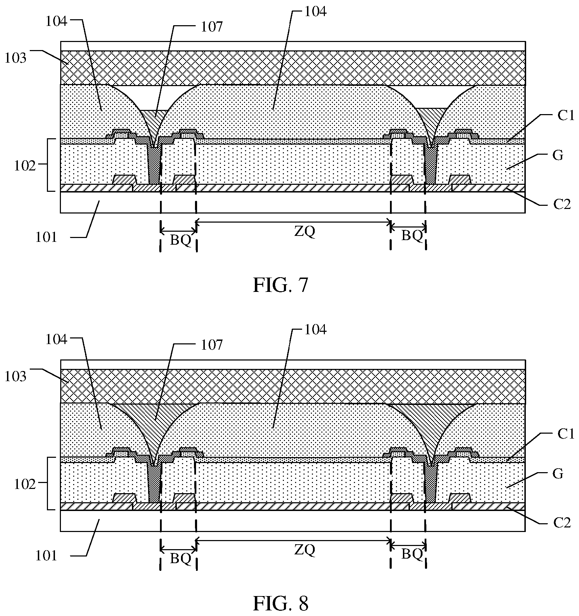

Another two embodiments, which are intended to further improve the image quality of the radiation imaging detector of the present disclosure, are shown in FIG. 7 and FIG. 8, respectively with their cross-sectional views.

As shown in FIG. 7 and FIG.8, a void would be created after superimposing the radiation conversion layer 103 on the array of the light-collecting structure 104, unless it is filled partially as shown in FIG.7, or filled completely as shown in FIG.8. By filling material 107 into the void, the void space shrank significantly or completely vanished. The means disclosed with these two embodiments, greatly reduce the risks of various process residues such as photoresistor, dust and moistures, and therefore increase the reliability of the radiation conversion layer, which might be dissolved gradually with moistures, and the lifetime of the radiation image detectors as well.

Filling the void completely as shown in FIG.8 may bring another benefit in terms of light collection efficiency. To minimize light reflection at the interface between the radiation conversion layer 103 and the filing unit 107, their indexes of refraction should be as close as possible. However, the index of refraction of the filing material should be less than the index of refraction of the convex lens-like light collection structure, to enable its light focusing functionality. Assume the index of refraction of the filling unit 107 equals to n1, and the refractive index of the light-collecting structure 104 equals to n2, it is preferable to have $n1 < n2$.

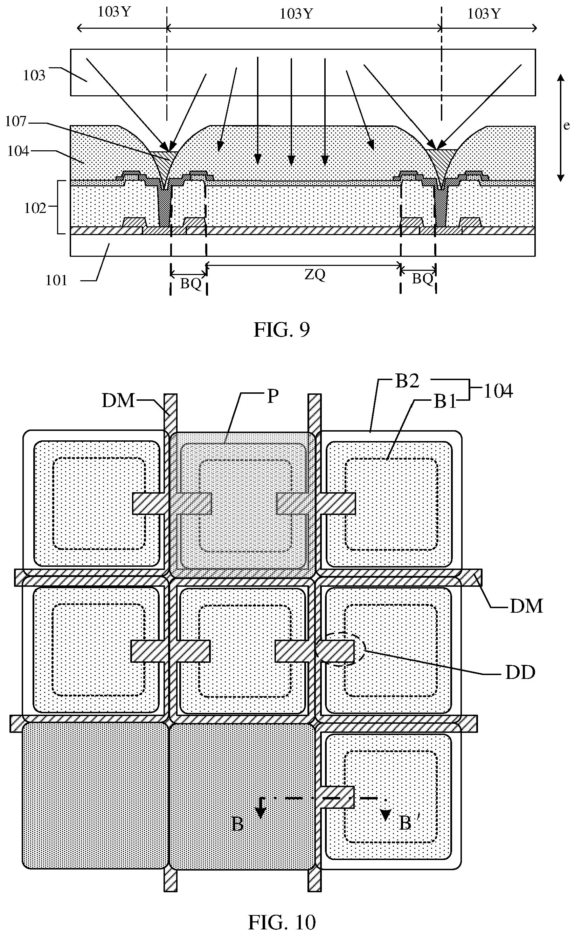

In another embodiment, the filling unit is made of materials including a material opaque to visible light, aiming to improve image MTF. FIG. 9 is a cross-sectional view of a radiation image detector according to the said embodiment. As illustrated in in FIG. 9, the radiation conversion layer 103 can be divided into pixelated blocks, corresponding to each photosensitive image pixel underneath. The visible light photons generated by an X-ray emit in all directions with essentially equal probabilities. Even with collimating effect such as light piping in CsI columnar structure, there are still a large fraction of the visible light photons, traveling in large angles respect to the direction perpendicular to the image sensor array 102 as indicated by an arrow e. Optical cross-talk will occur whenever light photons reach a neighbor pixel, just as the light traces illustrated in FIG.9. Since the filling unit 107 provided in the embodiment of the present disclosure is opaque to visible light, the visible light traces in large angles will have large chance to be blocked or absorbed by the filling unit 107. Therefore, the arrangement of utilizing the opaque filling unit in the said embodiment can effectively reduce optical cross-talks.

The materials used to make the filling unit includes one of the following or their combinations: an organic material mixed with black particles such as black dyes, carbon powders, carbon nanotubes, or chromium oxide particles.

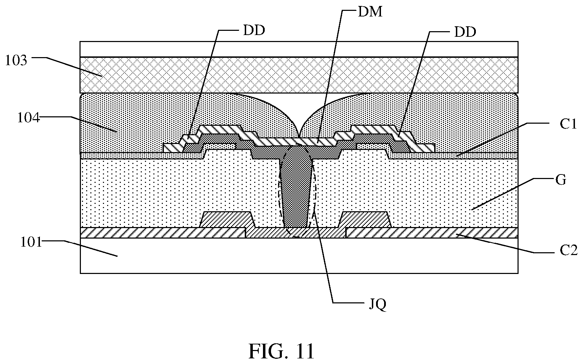

FIG. 10 is a plane view of a radiation image detector as another embodiment of the present disclosure, a cross-sectional view along a cutting line B-B' is schematically shown in FIG. 11.

**Claims**

1. A radiation image detector, comprising:

   a substrate (101);
   an optical image detector (102) located on the substrate (101), wherein the optical image detector (102) comprises an array comprising a plurality of photosensitive pixels (P) arranged periodically, wherein each of the plurality of photosensitive pixels (P) comprises a first electrode (C1), a photoelectric conversion layer (G) and a second electrode (C2), wherein the first electrode (C1) comprises a first contact surface (M1) in direct contact with the photoelectric conversion layer (G), the second electrode (C2) comprises a second contact surface (M2) in direct contact with the photoelectric conversion layer (G), and the photoelectric conversion layer (G) comprises a central region (ZQ) and a side wall region (BQ), wherein the side wall region (BQ) comprises a region of the photoelectric conversion layer (G) other than the central region (ZQ); and
   a plurality of trench regions (JQ) in a certain width, insensitive to light and surrounding each of the plurality of photosensitive pixels (P) of the array;
   a radiation conversion layer (103) located on a side of the optical image detector (102) facing away from the substrate (101) and configured to convert radiation into visible light; and
   a plurality of light-collecting structures (104) pixelated and located between the plurality of photosensitive pixels (P) and the radiation conversion layer (103), wherein the plurality of light-collecting structures (104) is configured to guide the visible light to the central region (ZQ), that the visible light would otherwise fall into the side wall region (BQ) or a trench region (JQ) between each photosensitive pixels (P),
   wherein each of the plurality of light-collecting structures (104) comprises a first portion (B1) which overlaps on the central region (ZQ), and a second portion (B2) which overlaps on both the sidewall region (BQ) and the trench regions (JQ);
   from the central region (ZQ) to the trench region (JQ), thickness of the second portion (B2) in the direction perpendicular to the substrate (101) gradually decreases while thickness of the first portion (B1) in the direction perpendicular to the substrate (101) is kept the same; and
   **characterized in that**,
   the central region (ZQ) comprises a portion where an orthographic projection of the first contact surface (M1) onto the photoelectric conversion layer (G) and an orthographic projection of the second contact surface (M2) onto the photoelectric conversion layer (G) overlap with each other, and that
   the maximum thickness (H) of the second portion (B2) satisfies the following equations:

   $$0.5(W2+W3) \geqq H \geqq (W2+W3),$$

   where W2 is the width of the side wall region (BQ), and W3 is the width of the trench regions (JQ).

2. The radiation image detector according to claim 1, wherein in each of the plurality of trench regions (JQ) and the side wall region (BQ), a space is formed between two adjacent light-collecting structures (104) of the plurality of light-collecting structures (104); and
   wherein the radiation image detector (102) further comprises a filling unit (107), and at least a part of the space is filled with the filling unit (107).

3. The radiation image detector according to claim 2, wherein the filling unit (107) is made of a material having a refractive index of n1 in the visible light, and the plurality of light-collecting structures (104) is made of a material having a refractive index of n2 in the visible light, where n1 < n2.

4. The radiation image detector according to claim 2, wherein the filling unit (107) is made of materials which is opaque to the visible light.

5. The radiation image detector according to claim 1, wherein the second portion (B2) is a ring-shaped convex lens having a focal point inside of the central region (ZQ).

**Patentansprüche**

1. Strahlungsbilddetektor, umfassend:

ein Substrat (101);
einen optischen Bilddetektor (102), der auf dem Substrat (101) angeordnet ist, wobei der optische Bilddetektor (102) ein Array umfasst, das mehrere periodisch angeordnete lichtempfindliche Pixel (P) umfasst, wobei jedes der mehreren lichtempfindlichen Pixel (P) eine erste Elektrode (C1), eine photoelektrische Umwandlungsschicht (G) und eine zweite Elektrode (C2) umfasst, wobei die erste Elektrode (C1) eine erste Kontaktfläche (M1) in direktem Kontakt mit der photoelektrischen Umwandlungsschicht (G) umfasst, die zweite Elektrode (C2) eine zweite Kontaktfläche (M2) in direktem Kontakt mit der photoelektrischen Umwandlungsschicht (G) umfasst und die photoelektrische Umwandlungsschicht (G) eine zentrale Region (ZQ) und eine Seitenwandregion (BQ) umfasst, wobei die Seitenwandregion (BQ) eine Region der photoelektrischen Umwandlungsschicht (G) umfasst, die sich von der zentralen Region (ZQ) unterscheidet; und
mehrere Grabenregionen (JQ) in einer bestimmten Breite, die unempfindlich gegenüber Licht sind und jede der mehreren lichtempfindlichen Pixel (P) des Array umgeben;
eine Strahlungsumwandlungsschicht (103), die auf einer dem Substrat (101) abgewandten Seite des optischen Bilddetektors (102) angeordnet und konfiguriert ist, Strahlung in sichtbares Licht umzuwandeln; und
mehrere Lichtsammelstrukturen (104), die verpixelt sind und zwischen den mehreren lichtempfindlichen Pixeln (P) und der Strahlungsumwandlungsschicht (103) angeordnet sind, wobei die mehreren Lichtsammelstrukturen (104) konfiguriert sind, das sichtbare Licht zu der zentralen Region (ZQ) zu leiten, wobei das sichtbare Licht andernfalls in die Seitenwandregion (BQ) oder eine Grabenregion (JQ) zwischen jedem der lichtempfindlichen Pixel (P) fallen würde,
wobei jede der mehreren Lichtsammelstrukturen (104) einen ersten Abschnitt (B1), der an der zentralen Region (ZQ) überlappt, und einen zweiten Abschnitt (B2), der sowohl an der Seitenwandregion (BQ) als auch an den Grabenregionen (JQ) überlappt, umfasst;
von der zentralen Region (ZQ) zu der Grabenregion (JQ) die Dicke des zweiten Abschnitts (B2) in der Richtung senkrecht zu dem Substrat (101) allmählich abnimmt, während die Dicke des ersten Abschnitts (B1) in der Richtung senkrecht zu dem Substrat (101) gleich gehalten wird; und
**dadurch gekennzeichnet, dass**
die zentrale Region (ZQ) einen Abschnitt umfasst, in dem eine orthografische Projektion der ersten Kontaktfläche (M1) auf die photoelektrische Umwandlungsschicht (G) und eine orthografische Projektion der zweiten Kontaktfläche (M2) auf die photoelektrische Umwandlungsschicht (G) einander überlappen, und dass
die maximale Dicke (H) des zweiten Abschnitts (B2) die folgenden Gleichungen erfüllt:

$$0,5(W2+W3) \geq H \geq (W2+W3),$$

wobei W2 die Breite der Seitenwandregion (BQ) und W3 die Breite der Grabenregionen (JQ) ist.

2. Strahlungsbilddetektor nach Anspruch 1, wobei in jeder der mehreren Grabenregionen (JQ) und der Seitenwandregion (BQ) ein Raum zwischen zwei benachbarten Lichtsammelstrukturen (104) der mehreren Lichtsammelstrukturen (104) gebildet ist; und
wobei der Strahlungsbilddetektor (102) ferner eine Fülleinheit (107) umfasst und mindestens ein Teil des Raums mit der Fülleinheit (107) gefüllt **ist.**

3. Strahlungsbilddetektor nach Anspruch 2, wobei die Fülleinheit (107) aus einem Material mit einem Brechungsindex von n1 im sichtbaren Licht hergestellt ist und die mehreren Lichtsammelstrukturen (104) aus einem Material mit einem Brechungsindex von n2 im sichtbaren Licht hergestellt sind, wobei n1 < n2 ist**.**

4. Strahlungsbilddetektor nach Anspruch 2, wobei die Fülleinheit (107) aus Materialien hergestellt ist, die für sichtbares Licht undurchlässig sind.

5. Strahlungsbilddetektor nach Anspruch 1, wobei der zweite Abschnitt (B2) eine ringförmige konvexe Linse mit einem Brennpunkt innerhalb der zentralen Region (ZQ) ist.

**Revendications**

1. Détecteur d'image de rayonnement, comprenant :

   un substrat (101) ;
   un détecteur d'image optique (102) situé sur le substrat (101), dans lequel le détecteur d'image optique (102) comprend un réseau comprenant une pluralité de pixels photosensibles (P) disposés périodiquement, dans lequel chacun de la pluralité de pixels photosensibles (P) comprend une première électrode (C1), une couche de conversion photoélectrique (G) et une deuxième électrode (C2), dans lequel la première électrode (C1) comprend une première surface de contact (M1) en contact direct avec la couche de conversion photoélectrique (G), la deuxième électrode (C2) comprend une deuxième surface de contact (M2) en contact direct avec la couche de conversion photoélectrique (G), et la couche de conversion photoélectrique (G) comprend une région centrale (ZQ) et une région de paroi latérale (BQ), dans lequel la région de paroi latérale (BQ) comprend une région de la couche de conversion photoélectrique (G) autre que la région centrale (ZQ) ; et
   une pluralité de régions de tranchée (JQ) d'une certaine largeur, insensibles à la lumière et entourant chacun de la pluralité de pixels photosensibles (P) du réseau ;
   une couche de conversion de rayonnement (103) située sur un côté du détecteur d'image optique (102) faisant face au substrat (101) et configurée pour convertir le rayonnement en lumière visible ; et
   une pluralité de structures de collecte de lumière (104) pixellisées et situées entre la pluralité de pixels photosensibles (P) et la couche de conversion de rayonnement (103), dans lequel la pluralité de structures de collecte de lumière (104) est configurée pour guider la lumière visible vers la région centrale (ZQ), de telle sorte que la lumière visible tombe autrement dans la région de paroi latérale (BQ) ou dans une région de tranchée (JQ) entre chaque pixel photosensible (P),
   dans lequel chacune de la pluralité de structures de collecte de lumière (104) comprend une première partie (B1) qui chevauche la région centrale (ZQ), et une deuxième partie (B2) qui chevauche à la fois la région de paroi latérale (BQ) et les régions de tranchée (JQ) ;
   à partir de la région centrale (ZQ) vers la région de tranchée (JQ), l'épaisseur de la deuxième partie (B2) dans la direction perpendiculaire au substrat (101) diminue progressivement tandis que l'épaisseur de la première partie (B1) dans la direction perpendiculaire au substrat (101) reste la même ; et
   **caractérisé en ce que**
   la région centrale (ZQ) comprend une partie où une projection orthographique de la première surface de contact (M1) sur la couche de conversion photoélectrique (G) et une projection orthographique de la deuxième surface de contact (M2) sur la couche de conversion photoélectrique (G) se chevauchent, et **en ce que**
   l'épaisseur maximale (H) de la deuxième partie (B2) satisfait aux équations suivantes :

$$0,5 \ (W2 + W3) \geq H \geq (W2 + W3)$$

   dans lesquelles W2 représente la largeur de la région de paroi latérale (BQ) et W3 représente la largeur des régions de tranchée (JQ).

2. Détecteur d'image de rayonnement selon la revendication 1, dans lequel, dans chacune des multiples régions de tranchée (JQ) et de la région de paroi latérale (BQ), un espace est formé entre deux structures de collecte de lumière adjacentes (104) parmi les multiples structures de collecte de lumière (104) ; et
   dans lequel le détecteur d'image de rayonnement (102) comprend en outre une unité de remplissage (107), et au moins une partie de l'espace est remplie avec l'unité de remplissage (107).

3. Détecteur d'image de rayonnement selon la revendication 2, dans lequel l'unité de remplissage (107) est constituée d'un matériau ayant un indice de réfraction n1 dans la lumière visible, et la pluralité de structures de collecte de lumière (104) est constituée d'un matériau ayant un indice de réfraction n2 dans la lumière visible, avec n1 < n2.

4. Détecteur d'image de rayonnement selon la revendication 2, dans lequel l'unité de remplissage (107) est constituée de matériaux qui sont opaques à la lumière visible.

5. Détecteur d'image de rayonnement selon la revendication 1, dans lequel la deuxième partie (B2) est une lentille convexe en forme d'anneau ayant un foyer à l'intérieur de la région centrale (ZQ).

FIG. 1

FIG. 2

FIG. 3

FIG. 4

FIG. 5

FIG. 6

FIG. 7

FIG. 8

FIG. 9

FIG. 10

DD    DM    DD

103

104    C1

G

101    C2

JQ

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017234992 A1
- US 2016021319 A1
- EP 2383586 A1